# EUROPEAN PATENT SPECIFICATION

(11) **EP 0 671 769 B1**
(45) Date of publication and mention of the grant of the patent: **12.05.2004**
(21) Application number: 95103519.5
(22) Date of filing: 10.03.1995
(51) Int. Cl.: H01L 29/78, H01L 29/06, H01L 29/10

(54) **Insulated gate field effect transistor**
Feldeffekttransistor mit isolierter Steuerelektrode
Transistor à effet de champ à grille isolée

(30) Priority: 10.03.1994 JP 3987494
(43) Date of publication of application: 13.09.1995
(73) Proprietor: DENSO CORPORATION, Kariya-City, Aichi-Pref. (JP)
(72) Inventor: Okabe, Naoto, Chita-gun, Aichi (JP); Kato, Naoto, Kariya-shi, Aichi (JP)
(74) Representative: Winter, Brandl, Fürniss, Hübner, Röss, Kaiser, Polte Partnerschaft

(56) References cited:
- EP-A- 0 503 605
- US-A- 5 170 241
- US-A- 5 196 354
- US-A- 5 208 471
- PATENT ABSTRACTS OF JAPAN vol. 013, no. 201 (E-757), 12 May 1989 & JP 01 022067 A (TOSHIBA CORP), 25 January 1989

## Description

### BACKGROUND OF THE INVENTION

### 1. Field of the Invention

The present invention relates to an insulated gate field effect transistor advantageously applicable as a high proof voltage and high current power switching element such as an inverter for starting a motor, a power supply, an igniter, etc.

### 2. Description of the Related Art

An insulated gate field effect transistor has a MOS structure and is driven by voltage, so that it operates using a lower power than a bipolar transistor and does not easily cause thermal runaway. It includes a power MOSFET (DMOS), which is a unipolar device, and an IGBT, which is a bipolar device. The IGBT has a structure similar to that of the power MOSFET, except that the former has a pn junction in a drain region to cause conductivity modulation in the high resistivity drain layer during operation thereby simultaneously providing both a high proof voltage and a low ON-resistance that are not attainable by a power MOSFET.

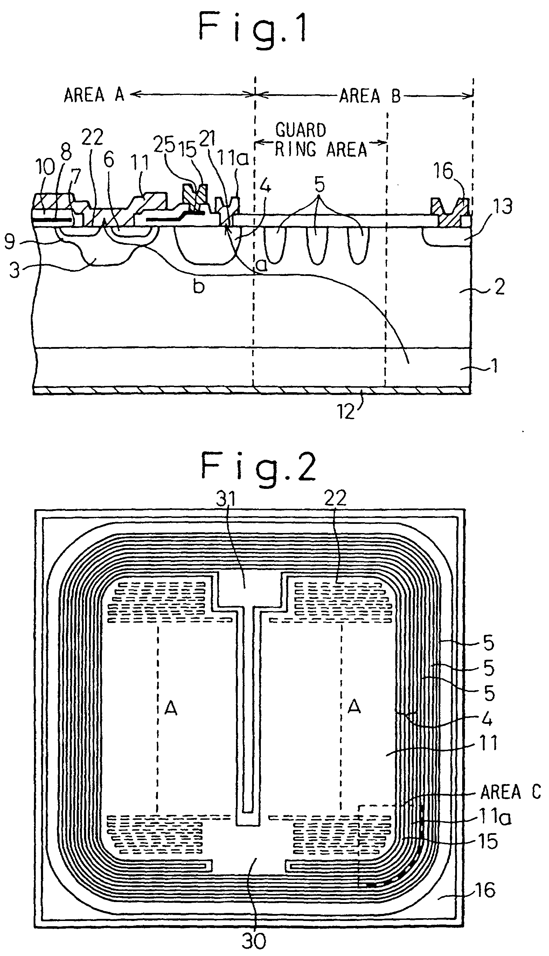

For example, Fig. 1 is a sectional view showing part of an IGBT having a cell area surrounded by a guard ring area for ensuring a high proof voltage. This structure is fabricated by the following process.

A semiconductor substrate consists of a p⁺ layer 1 (first semiconductor layer). A high resistivity n⁻ layer 2 (second semiconductor layer) is formed on the p⁺ layer 1 by chemical vapor deposition process. Then, p layers 3, 4, and 5 (third, fourth, and fifth semiconductor layers) are simultaneously formed to a depth of 3 to 6 µm by selective diffusion. p layer 9 and n⁺ layer 6 (fourth semiconductor layer) are then formed by selective diffusion. This process includes oxidization of the surface of the n⁻ layer 2 to form a gate oxide or insulating film 7, on which a gate electrode 8 is then formed and utilized as a mask in a DSA process to form the p layer 9 and the n⁺ layer (source region) 6 in a self-aligned manner to provide a channel. Thereafter, an interlaminar insulating layer 10 is formed and then, to provide ohmic contacts to the p layer 3, the n ⁺ layer 6, and the p layer 4, contact holes are opened through the upper oxide layer. A several µm thick aluminum layer is then deposited and selectively etched to form a source electrode 11, a gate electrode lead line 15, and a source electrode lead line 11a. On the reverse side of the p⁺ layer 1, a metal layer is deposited to provide a drain electrode 12.

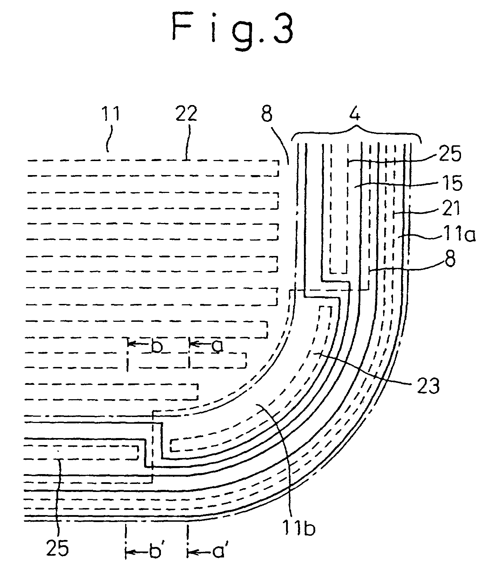

Fig. 2 is a plan view of a device having the cross-sectional structure shown in Fig. 1. In Fig. 2, the source electrodes 11 are shown as grooved stripes 22 which, together with p wells consisting of the p regions 3 and 9 (hereinafter collectively referred to as "p well 3/9" or "p region 3/9"), are repeated at a selected interval to compose a cell area A, such that the cell area A has the source electrodes 11 on the top surface. The cell area A has the periphery surrounded by the p region 4, on which the source electrode lead line 11a, the gate electrode lead line 15, a source electrode pad 30, and a gate electrode pad 31 are formed. As shown in Fig. 1, the source electrode lead line 11a and the gate electrode lead line 15 have respective contact holes 21 and 25 extending through insulating layers. The source electrode lead line 11a fixes the potential over the whole device and ensures uniform potential upon operation.

One or more guard rings 5 surround the p region 4 with a selected space therebetween. The guard rings 5 compose a guard ring area surrounded by a channel stopper region 13 to suppress propagation of, and avoid influence by, any depletion layer occurring when the substrate periphery is subjected to a high voltage. An equipotential ring 16 imparts a uniform potential to the channel stopper region 13 entirely.

In the above construction, when a voltage is applied to the gate electrode 8, a channel is formed to provide a current path between the drain electrode 12 and the source electrode 11.

In contrast to this normal operation, a surge voltage greater than the normal operating voltage is occasionally applied across the drain electrode 12 and the source electrode 11. Under such a condition, the pn junction composed of the p well 3/9 and the n⁻ layer 2 is reverse-biassed, so that a depletion layer propagates in the high resistivity n⁻ layer 2. In the area A of Fig. 2, the depletion layer propagates to the neighboring p wells 3/9 and the intervening n⁻ layer 2 to cause mutual overlap thereby relaxing the working electric field. A maximum electric field E_{A} thus occurs at the pn junction at the bottom of the p well 3/9.

On the other hand, the p layer 4 is located outside of the periphery of the p well 3/9. In the area B extending from the outer end of the p layer 4 to the free end of the n⁻ layer 2, the above relaxation of the electric field does not occur, so that a maximum electric field E_{B} occurs along the periphery of the p layer 4 or in the vicinity thereof at the surface of the n ⁻ layer 2.

It is generally true that E_{A} > E_{B}. To improve the proof voltage of the area B, or of the device, by decreasing the E _{B} value close to the E _{A} value, the guard rings 5 are repeatedly arranged to decrease the maximum field E _{B} of the area B.

When a surge voltage is applied to the drain electrode 12, the electric field E_{G} in the guard ring area is raised, so that a large number of electron-hole pairs are generated in the area outside of the outermost guard ring of the guard ring area due to impact ionization. Under this condition, the electric field E _{G} in the guard ring area is greater in a curved portion of the guard ring area than in a linear portion, when seen on a plan view. Among the generated carriers, the holes flow out to the source electrode 11 or the source electrode lead line 11a and the electrons flow to the p⁺ layer or substrate 1, into which other holes are newly introduced. This phenomenon includes occurrence of currents flowing along the paths shown by the arrows in Fig. 1. A current along path "a" is conducted through the thin source lead line 11a along the p layer 4 to the source electrode pad 30, which includes a relatively high resistivity to the current, so that the current "a" is less in amount than the current "b" which flows directly to the source electrode 11. This results in greater current concentration in the cell area A near the curved portion of the guard ring area than in the cell area A along the linear portion of the the guard ring.

Consequently, a high current "b" flows through the p layer 9 in the cell area A near the curved portion of the guard ring to cause a voltage reduction leading to a forward-biassing at the pn junction between the n⁺ layer 6 and the p layer 9, which activates a parasitic transistor to cause breakdown due to current concentration.

To improve the antibreakdown endurance, the guard ring area must have an improved proof voltage. To provide an improved proof voltage of the guard ring area, the guard rings or diffused regions must be increased in depth and/or number. However, when a diffused region is formed to an increased depth, the obtained diffused region is also increased in width and consequently, the guard ring area occupies an increased area in the device. Moreover, the diffusion regions of the guard ring are usually formed simultaneously with the diffusion regions in the cell area in order to reduce the number of the necessary photolithographic masks, so that an increase in the width of the former is associated with an increase in the width of the latter resulting in a further increase in the area of the device chip. On the other hand, increase in the number of the diffused region of the guard ring area also requires an increased area occupied by the guard ring area, leading to an increase in the chip area.

The same problem occurs in MOSFETs in that, although an n-type semiconductor substrate 1 does not inject the minority carriers (or holes in this case) into a transistor formed therein, an unusually high electric field developed in the guard ring area generates a flow of impact-ionized carriers which forms a large current flowing through the p layer 9 near the curved portion of the guard ring area, and the resulting voltage reduction causes forward-biassing of the pn junction between the n⁺ layer 6 and the p layer 9, which activates a parasitic transistor to cause breakdown due to current concentration.

Here, US5196354 and EP0503605 disclose a DMOSFET device having a MOSFET section and a field limiting section arranged to substantially surround the MOSFET section. US5196354 further discloses a p-type region, in the field limiting section thereof, which is provided inside field limiting rings and connected to a source electrode. US5170241, JP01-22067 and US5208471 also disclose a DMOSFET with an annular region which surrounds DMOS cells and is connected to a source electrode.

### SUMMARY OF THE INVENTION

The object of the present invention is to solve the above-mentioned conventional problems, specifically to provide an insulated gate field effect transistor having an improved antibreakdown endurance of devices against an unusually increased electric field intensity in the guard ring area or size.

To achieve the object according to the present invention, there is provided an insulated gate field effect transistor comprising: a first semiconductor layer; a second semiconductor layer of a first conductivity type in contact with said first semiconductor layer; a third semiconductor layer of a second conductivity type formed in said second semiconductor layer, with a junction between said second semiconductor layer and said third semiconductor layer terminating at a surface of said second semiconductor layer; a fourth semiconductor layer of the first conductivity type formed in said third semiconductor layer, with a junction between said third semiconductor layer and said fourth semiconductor layer terminating at a surface of said third semiconductor layer; a gate electrode formed, via a gate insulating film, at least over a channel region provided by a surface of said third semiconductor layer in a portion between said second semiconductor layer and said fourth semiconductor layer; a source electrode in contact with both said third semiconductor layer and said fourth semiconductor layer; a drain electrode for supplying a drain current through said first semiconductor layer; a cell area, made up of a plurality of said third semiconductor layers, wherein said gate electrode, said source electrode and said drain electrode are commonly provided for said plurality of said third semiconductor layers in said cell area, respectively; a guard ring area formed between said cell area and a periphery of said second semiconductor layer to provide a band pattern surrounding said cell area having a curved portion; and a fifth semiconductor layer of the second conductivity type, formed between said cell area and said guard ring area; wherein said source electrode has a plurality of extensions connected to said fifth semiconductor layer in first contact regions to provide by-passes through which, when a current concentration occurs within said guard ring area, the concentrated current is conducted directly to said source electrode in said cell area, and a gate electrode lead line is formed on said fifth semiconductor layer and is connected to the gate electrode in at least one second contact region, wherein between the first contact regions the gate electrode is formed.

The dependent claims are directed to preferred embodiments of the invention.

The source electrode may include a cell portion connected to the source region in a first well and a pad portion connected to an external lead electrode, and the bypass includes the extension of the cell portion of the source electrode.

According to another embodiment, the source electrode includes a cell portion connected to the source region in the third semiconductor layer and a pad portion connected to an external lead electrode, and the by-pass includes the extension of the cell portion of the source electrode.

The cell area may comprise cells in the form of a stripe or polygon.

The curved portion of the guard ring area may comprise either a smooth curve or one or more angular edges.

In one embodiment, the fifth semiconductor layer is formed outside and surrounding the cell area and both a gate electrode lead line and a source electrode lead line are formed on the fifth semiconductor layer. In another embodiment, either a source electrode lead line or a gate electrode lead line is formed on the fifth semiconductor layer.

Preferably, in the vicinity of the curved portion of the guard ring area, a contact between the gate electrode of the cell area and the gate electrode lead line formed on the fifth semiconductor layer and a contact between the extension of the source electrode and the fifth semiconductor layer are alternately disposed.

Preferably, along the entire periphery of the cell area, a contact between the gate electrode of the cell area and the gate electrode lead line formed on the fifth semiconductor layer and a contact between the extension of the source electrode and the fifth semiconductor layer are alternately disposed.

Preferably, inside the curved portion of the guard ring, between the fifth semiconductor layer and the cell area, a sixth semiconductor layer of the second conductivity type is provided and connected to the source electrode of the cell area.

### BRIEF DESCRIPTION OF THE DRAWINGS

Figure 1 shows a conventional insulated gate bipolar transistor (IGBT), in a sectional view;
Fig. 2 shows a layout pattern of an entire device chip including the IGBT of Fig. 1, in a plan view;
Fig. 3 partially shows a layout pattern of a device chip including an IGBT according to the first embodiment of the present invention, in a plan view;
Fig. 4 shows the IGBT of the first embodiment, in a cross-sectional view along line a-a' of Fig. 3;
Fig. 5 shows the IGBT of the first embodiment, in another cross-sectional view along line b-b' of Fig. 3;
Fig. 6 partially shows a layout pattern of a device chip including an IGBT according to the second embodiment of the present invention, in a plan view;
Fig. 7 shows the IGBT of the second embodiment, in a cross-sectional view along line a-a' of Fig. 6;
Fig. 8 shows the IGBT of the second embodiment, in another cross-sectional view along line b-b' of Fig. 6;
Fig. 9 partially shows a layout pattern of a device chip including an IGBT according to the third embodiment of the present invention, in a plan view;
Fig. 10 shows the IGBT of the third embodiment, in a cross-sectional view along line a-a' of Fig. 9;
Fig. 11 shows the IGBT of the third embodiment, in another cross-sectional view along line b-b' of Fig. 9;
Fig. 12 partially shows a layout pattern of a device chip including an IGBT according to the fourth embodiment of the present invention, in a plan view;
Fig. 13 shows the IGBT of the fourth embodiment, in a cross-sectional view along line a-a' of Fig. 12; and
Fig. 14 shows the IGBT of the fourth embodiment, in another cross-sectional view along line b-b' of Fig. 12.

### DESCRIPTION OF THE PREFERRED EMBODIMENTS

According to the first and second aspects of the present invention, when a surge voltage causes a current concentration in the guard ring area, the concentrated current is directly conducted through a by-pass to the source electrode in the cell area to thereby prevent forward-biassing between the well and the source region due to the concentrated current, so that the device has an advantageously improved antibreakdown endurance against an unusually increased electric field intensity in the guard ring area due to the surge voltage.

According to the third aspect of the present invention, the third semiconductor layer in the vicinity of the curved portion of the guard ring area is a dummy layer not containing the fourth semiconductor layer, so that, even when a surge voltage causes a current concentration in the vicinity of the guard ring area, the dummy layer has no pn junctions and does not cause a "latched-up" or interrupted state of the transistor, thereby advantageously providing an improved antibreakdown endurance.

### Example 1

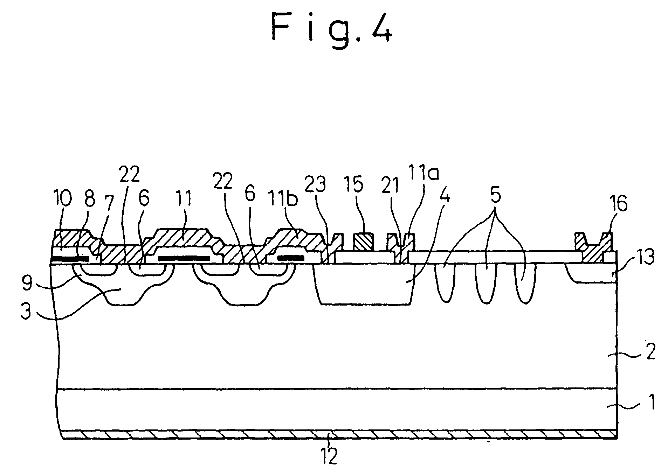

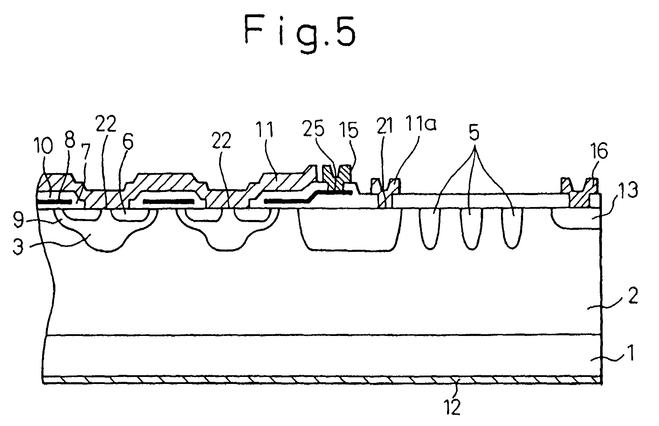

Figures 3 to 5 show the first embodiment of the present invention. The shown n-channel IGBT has the same chip layout pattern as shown in Fig. 2, except that the corner area C of Fig. 2 is replaced by a different arrangement shown in Fig. 3. The area C represents four corners of the chip layout pattern which have the same arrangement. Figures 4 and 5 show cross sections along lines a-a' and b-b' of Fig. 3, respectively, including the guard ring area. Cross sections will be shown in the same manner in the later Examples. The same symbols denote the corresponding portions of the structure shown in Fig. 1.

The first embodiment of the present invention is different from the conventional structure shown in Figs. 1 and 2 in that, in the corner area C, a source electrode 11 has an extension 11b extending outwardly from the cell area and brought into contact with the p region 4 via a contact hole 23 through an interlaminar insulating layer 10, as can be seen from the plan view pattern of Fig. 3 and the cross section of Fig. 4.

In this arrangement, when an applied surge voltage imparts a plus potential to the drain electrode 12 relative to the source electrode 11, an intense electric field is generated in the vicinity of the corner of the guard ring area and carriers are generated by impact ionization. When the thus-generated carriers flows as a current toward the source electrode 11 of the cell area, the extension 11b of the source electrode 11 extracts the flowing carriers or excess current through the p region 4 to reduce the amount of the current flowing into the cell area. Namely, the extension 11b forms a by-pass which directly conducts the generated current to the source electrode 11 and thereby, prevents the occurrence of a forward biassing between the p well 3/9 and the source region 6 and the resulting "latch-up" of the transistor, to consequently provide an improved antibreakdown endurance.

It should be noted that this embodiment has a plan-view arrangement in which the region 11b forms the by-pass in the curved or corner portions whereas the region 15 forms the gate electrode lead line in the linear portions. Both the corner and linear portions have an outermost source electrode lead line 11a.

Typically, the source electrode 11 may include a cell portion 22 (Fig. 2) connected to the source region 6 in the first or p well 3/9 and a pad portion 30 (Fig. 2) connected to an external lead electrode, and the by-pass includes the extension 11b of the cell portion 22 (Fig. 2) of the source electrode 11.

### Example 2

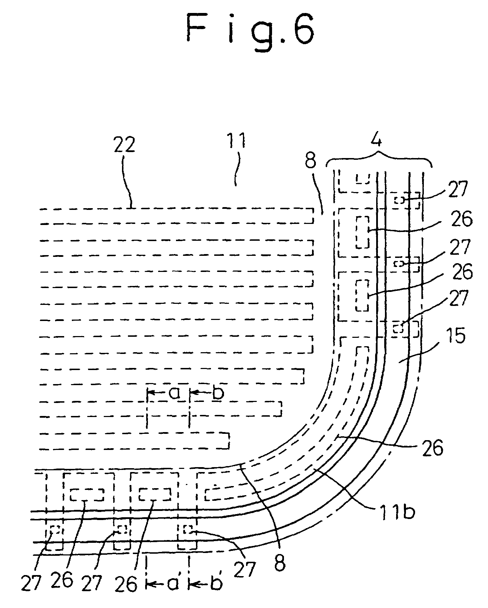

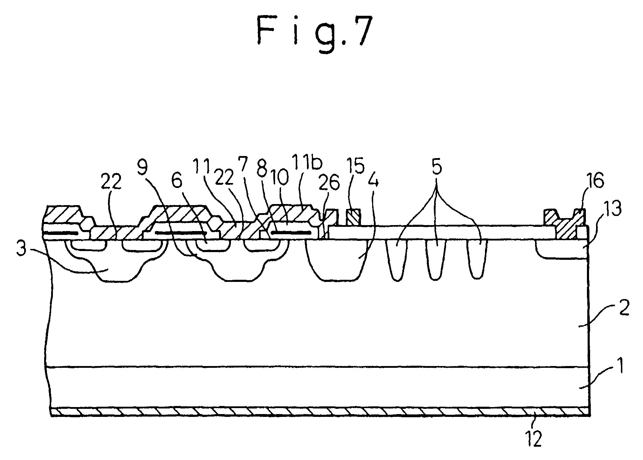

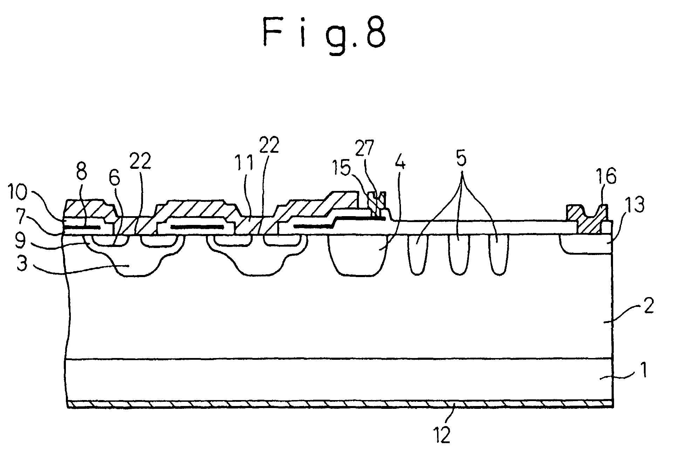

Figures 6 to 8 show the second embodiment of the present invention. Figure 6 shows the corner area C, Figs. 7 and 8 show cross sections along lines a-a' and b-b' of Fig. 6, respectively.

This second embodiment has the same feature as the first embodiment in that, in the corner area C, a source electrode 11 has an extension 11b extending outwardly from the cell area and brought into contact with the p region 4 via a contact hole 23 through an interlaminar insulating layer 10, as can be seen in Fig. 7.

Moreover, the second embodiment also has an additional feature that a contact region 26 in which the extension 11b of the source electrode 11 is in contact with the p region 4 and a contact region 27 in which an extension of the gate electrode 8 is in contact with the gate lead line 15 are alternately disposed, at least along the linear portion of the guard ring area in the vicinity of the curved portion thereof.

The additional feature of the second embodiment provides an additional advantage that the area for extracting the excess current is increased in the unit area of the device to further decrease the current flowing into the cell area and prevent occurrence of the "latch-up", thereby further improving the antibreakdown endurance.

If the alternate contact region pattern of this embodiment entirely surrounds the periphery of the cell area, the carrier extracting extension 11b, which is in contact with the p region 4 through the contact hole 26, also stabilizes the peripheral potential, so that the source lead line 11a is not necessary and the area of the p region 4 can be reduced. It is also advantageous that, when an inversion layer is formed in the channel, the electron current through the channel is protected from a hole current concentration because holes injected from the p⁺ layer 1 are also extracted, thereby improving the anti-"latch-up" endurance.

### Example 3

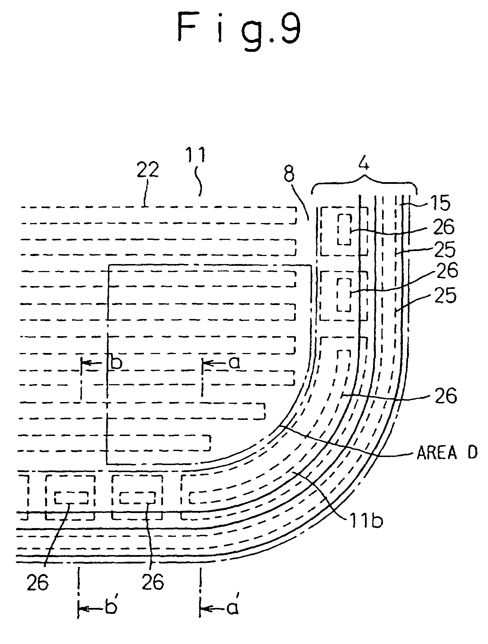

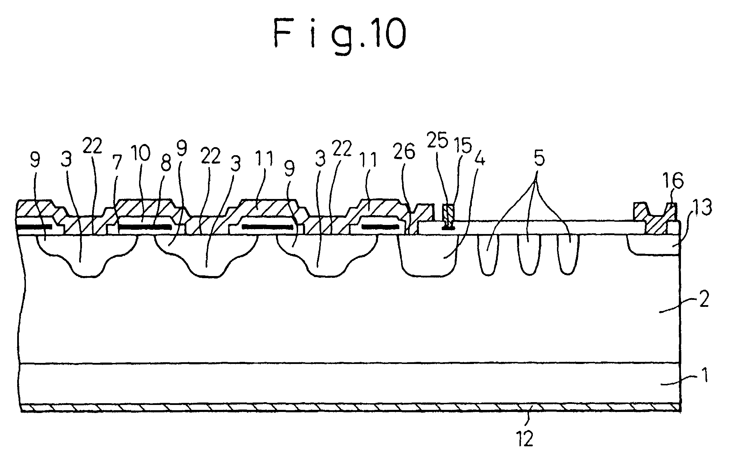

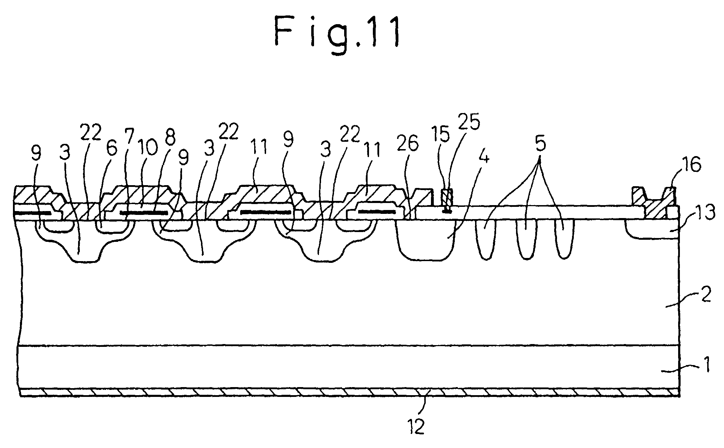

Figures 9 to 11 show the third embodiment of the present invention. Figure 9 shows the corner area C, and Figs. 10 and 11 show cross sections along lines a-a' and b-b' of Fig. 9, respectively.

The third embodiment has a feature that, in the area D defined by a double-dotted line shown in Fig. 9, in the cell area in the vicinity of the curved portion of the guard ring area shown in Fig. 10, the n⁺ source region 6 is not formed in the p well 3/9 so that the p well 3/9 is a dummy layer in the limited area D.

This feature of the third embodiment has an advantage that, even when a surge voltage generates an intense electric field in the vicinity of the curved portion of the guard ring and a current of carriers generated by impact ionization flows toward the source electrode 11, the absence of the n⁺ region 6 ensures the absence of a parasitic transistor structure, so that the antibreakdown endurance is improved by the absence of a parasitic transistor operation.

Namely, according to the third embodiment, the corner area C contains no channel regions and therefore, accepts no injection of an electron current, so that the injected hole amount is also reduced and the area for extracting the excess current is increased, which both synergistically improve the anti-"latch-up" endurance.

The p regions 3/9 of the area D have the same shape and pitch as those of the cell area, so that application of a drain voltage can produce the same propagation manner of the depletion layer, i.e., the same electric field distribution, in both the area D and the cell area to establish uniform potential distribution over the entire chip area. This ensures a uniform junction current without current concentration even under a surge voltage occurring at a large dv/dt value. The p regions 3/9 may be separately formed in the area D and in the cell area.

### Example 4

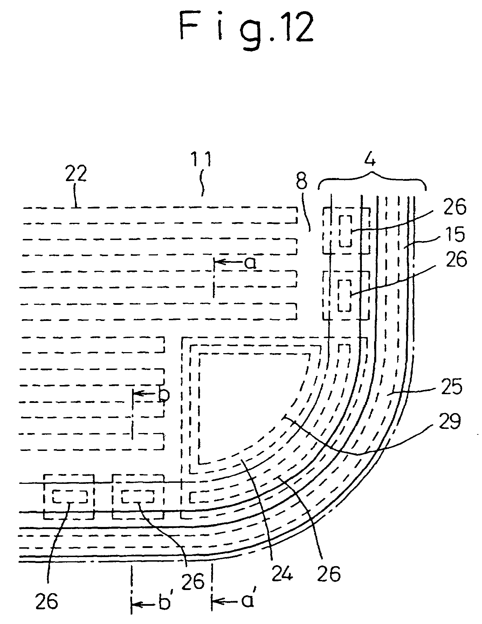

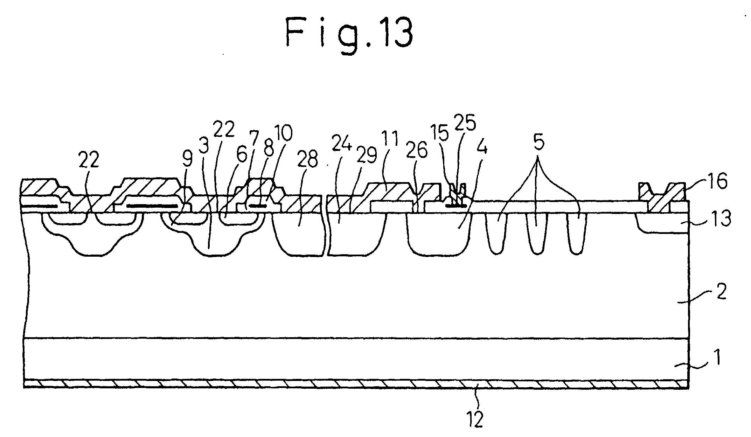

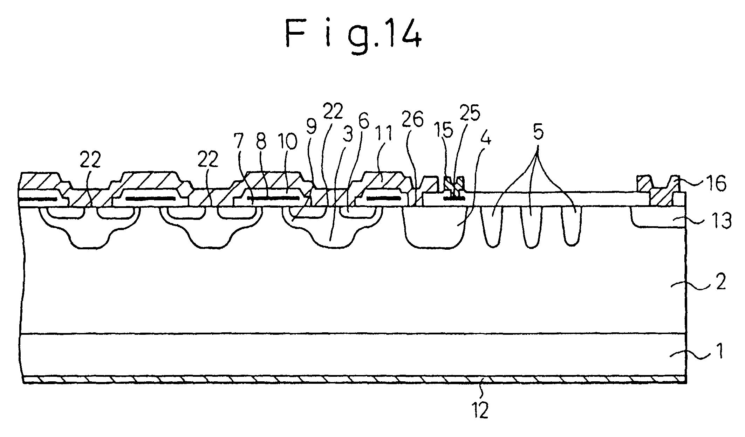

Figures 12 to 13 show the fourth embodiment of the present invention. Figure 12 shows the corner area C and Figs. 13 and 14 show cross sections along lines a-a' and b-b' of Fig. 12, respectively.

The fourth embodiment has a feature that a p region 24 is provided between the cell area and the p region 4 and the extension of the source electrode 11 is in contact with the p region 24 via a contact hole 29 through an insulating layer.

This feature provides an advantage that, when a surge voltage generates an intense electric field in the vicinity of the curved portion of the guard ring and a current of carriers generated by impact ionization flows toward the source electrode 11, the p region 24 extracts carriers through the contact hole 29, thereby prevents the occurrence of current concentration to the cell area in the corner area C, suppresses activation of a parasitic transistor in the cell area, and improves the antibreakdown endurance.

Namely, according to the fourth embodiment, an enlarged area of contact with the p regions provides an advantage that, when an inversion layer is formed in the channel, the electron current through the channel is protected from a hole current concentration to the cell area near the corner area C, because holes injected from the p⁺ layer 1 are extracted to prevent the current concentration.

If the extracting region has a fan or sector shape, when a current of holes from the curved portion of the guard ring area of the corner area C flows toward the cell area, the hole current can be more efficiently extracted. The p region 24 and the contact hole 29 may have an increased dimension either in the X or Y coordinate directions on the plan view. The p regions 24 and 4 may be unified and the contact holes 26 and 29 may also be unified.

Although Examples 1 through 4 described a stripe cell pattern, it can be readily recognized that a cell pattern in the form of a quadrangle, hexagon, octagon, or other polygons will provide the same advantages as described above according to the present invention.

Two or more of the above-described embodiments may be combined to provide a further improved antibreakdown endurance. For example, the third and fourth embodiments include the feature of the second embodiment and can be recognized as a modification of the second embodiment.

The curved portion of the guard ring area may not be an entirely smooth curve but may contain one or more angular edges.

It should also be appreciated that, although Examples 1 to 4 describe an n-channel IGBT, the present invention may also be evenly applied to a p-channel IGBT.

Example 1 may be also applied to a MOSFET having a first semiconductor layer made of an n⁺ layer.

## Claims

1. An insulated gate field effect transistor comprising:
a first semiconductor layer (1);
a second semiconductor layer (2) of a first conductivity type (n) in contact with said first semiconductor layer;
a third semiconductor layer (3, 9) of a second conductivity type (p) formed in said second semiconductor layer, with a junction between said second semiconductor layer and said third semiconductor layer terminating at a surface of said second semiconductor layer;
a fourth semiconductor layer (6) of the first conductivity type formed in said third semiconductor layer, with a junction between said third semiconductor layer and said fourth semiconductor layer terminating at a surface of said third semiconductor layer;
a gate electrode (8) formed, via a gate insulating film (7), at least over a channel region provided by a surface of said third semiconductor layer in a portion between said second semiconductor layer and said fourth semiconductor layer;
a source electrode (11) in contact with both said third semiconductor layer and said fourth semiconductor layer;
a drain electrode (12) for supplying a drain current through said first semiconductor layer;
a cell area, made up of a plurality of said third semiconductor layers (3, 9), wherein said gate electrode (8), said source electrode (11) and said drain electrode (12) are commonly provided for said plurality of said third semiconductor layers in said cell area, respectively;
a guard ring area (5) formed between said cell area and a periphery of said second semiconductor layer to provide a band pattern surrounding said cell area having a curved portion; and
a fifth semiconductor layer (4) of the second conductivity type, formed between said cell area and said guard ring area;
***characterized in that:***
said source electrode (11) has a plurality of extensions (11b) connected to said fifth semiconductor layer (4) in first contact regions (23, 26) to provide by-passes through which, when a current concentration occurs within said guard ring area, the concentrated current is conducted directly to said source electrode in said cell area, and
a gate electrode lead line (15) is formed on said fifth semiconductor layer (4) and is connected to the gate electrode (8) in at least one second contact region (25, 27), wherein
between the first contact regions (23, 26) the gate electrode (8) is formed such that the plurality of extensions (11b) and the gate electrode (8) are alternately disposed along the periphery of the cell area.

2. Insulated gate field effect transistor according to claim 1, wherein on a curved portion of said fifth semiconductor layer (4) one of said first contact regions (23, 26) is disposed.

3. Insulated gate field effect transistor according to claims 1 or 2, wherein a plurality of second contact regions (25, 27) are provided, which are disposed alternately with said first contact regions (23, 26) along the periphery of said cell area.

4. Insulated gate field effect transistor according to claim 2, wherein in a portion of said cell area adjacent to said curved portion of said fifth semiconductor layer (4) said fourth semiconductor layer (6) is not disposed within said third semiconductor layer (3, 9).

5. Insulated gate field effect transistor according to claim 2, wherein in a portion of said cell area adjacent to said curved portion of said fifth semiconductor layer (4) a sixth semiconductor layer (24) of the second conductivity type is provided and connected to said source electrode (11).

6. Insulated gate field effect transistor according to any one of claims 1 to 5, wherein said cell area comprises cells in the form of a stripe or polygon.

7. Insulated gate field effect transistor according to any one of claims 1 to 6, wherein said curved portion of said guard area comprises either a smooth curve or one or more angular edges.

## Patentansprüche

1. Feldeffekttransistor mit isoliertem Gate, der aufweist:
eine erste Halbleiterschicht (1),
eine zweite Halbleiterschicht (2) eines ersten Leitungstyps (n) in Kontakt mit der ersten Halbleiterschicht,
eine dritte Halbleiterschicht (3, 9) eines zweiten Leitungstyps (p), die in der zweiten Halbleiterschicht ausgebildet ist, mit einem Übergang zwischen der zweiten Halbleiterschicht und der dritten Halbleiterschicht, die an einer Oberfläche der zweiten Halbleiterschicht abschließt,
eine vierte Halbleiterschicht (6) des ersten Leitungstyps, die in der dritten Halbleiterschicht ausgebildet ist, mit einem Übergang zwischen der dritten Halbleiterschicht und der vierten Halbleiterschicht, die an einer Oberfläche der dritten Halbleiterschicht abschließt,
eine Gateelektrode (8), die mittels eines Gateisolierfilmes (7) mindestens über einem Kanalbereich ausgebildet ist, der durch eine Oberfläche der dritten Halbleiterschicht in einem Abschnitt zwischen der zweiten Halbleiterschicht und der vierten Halbleiterschicht vorgesehen ist,
eine Sourceelektrode (11) in Kontakt mit der dritten Halbleiterschicht und der vierten Halbleiterschicht,
eine Drainelektrode (12) zur Zufuhr eines Drainstromes durch die erste Halbleiterschicht,
einen Zellbereich, der aus mehreren dritten Halbleiterschichten (3, 9) besteht, wobei die Gateelektrode (8), die Sourceelektrode (11) und die Drainelektrode (12) jeweils gemeinsam für die dritten Halbleiterschichten im Zellbereich vorgesehen sind,
einen Schutzringbereich (5), der zwischen dem Zellbereich und einem Umfang der zweiten Halbleiterschicht vorgesehen ist, um ein Bandmuster bereitzustellen, das den Zellbereich mit einem Kurvenabschnitt umgibt, und
eine fünfte Halbleiterschicht (4) des zweiten Leitungstyps, die zwischen dem Zellbereich und dem Schutzringbereich ausgebildet ist,
**dadurch gekennzeichnet, daß**
die Sourceelektrode (11) mehrere Verlängerungen (11b) aufweist, die mit der fünften Halbleiterschicht (4) in ersten Kontaktbereichen (23, 26) verbunden sind, um Bypässe durch diese bereitzustellen, wenn eine Stromkonzentration innerhalb des Schutzringbereiches auftritt, wobei der konzentrierte Strom direkt zur Sourceelektrode im Zellbereich geleitet wird, und
eine Gateelektrodenleitung (15) auf der fünften Halbleiterschicht (4) ausgebildet und mit der Gateelektrode (8) in mindestens einem zweiten Kontaktbereich (25, 27) verbunden ist, wobei
die Gateelektrode (8) zwischen den ersten Kontaktbereichen (23, 26) ausgebildet ist, so daß die Verlängerungen (11b) und die Gateelektrode (8) entlang des Umfangs des Zellbereiches abwechselnd angeordnet sind.

2. Feldeffekttransistor mit isoliertem Gate nach Anspruch 1, wobei auf einem Kurvenabschnitt der fünften Halbleiterschicht (4) einer der ersten Kontaktbereiche (23, 26) angeordnet ist.

3. Feldeffekttransistor mit isoliertem Gate nach Anspruch 1 oder 2, wobei mehrere zweite Kontaktbereiche (25, 27) vorgesehen sind, die abwechselnd mit den ersten Kontaktbereichen (23, 26) entlang des Umfangs des Zellbereiches angeordnet sind.

4. Feldeffekttransistor mit isoliertem Gate nach Anspruch 2, wobei in einem Abschnitt des Zellbereiches neben dem Kurvenabschnitt der fünften Halbleiterschicht (4) die vierte Halbleiterschicht (6) innerhalb der dritten Halbleiterschicht (3, 9) nicht angeordnet ist.

5. Feldeffekttransistor mit isoliertem Gate nach Anspruch 2, wobei in einem Abschnitt des Zellbereiches neben dem Kurvenabschnitt der fünften Halbleiterschicht (4) eine sechste Halbleiterschicht (24) des zweiten Leitungstyps vorgesehen und mit der Sourceelektrode (11) verbunden ist.

6. Feldeffekttransistor mit isoliertem Gate nach einem der Ansprüche 1 bis 5, wobei der Zellbereich Zellen in Streifen- oder Polygonform aufweist.

7. Feldeffekttransistor mit isoliertem Gate nach einem der Ansprüche 1 bis 6, wobei der Kurvenabschnitt des Schutzbereiches entweder eine glatte Kurve oder eine oder mehrere abgewinkelte Kanten aufweist.

## Revendications

1. Transistor à effet de champ à grille isolée comprenant :
une première couche semi-conductrice (1) ;
une deuxième couche semi-conductrice (2) d'un premier type de conductivité (n) en contact avec ladite première couche semi-conductrice ;
une troisième couche semi-conductrice (3, 9) d'un deuxième type de conductivité (p) constituée dans ladite deuxième couche semi-conductrice, avec une jonction entre ladite deuxième couche semi-conductrice et ladite troisième couche semi-conductrice, se terminant à une surface de ladite deuxième couche semi-conductrice ;
une quatrième couche semi-conductrice (6) du premier type de conductivité constituée dans ladite troisième couche semi-conductrice, avec une jonction entre ladite troisième couche semi-conductrice et ladite quatrième couche semi-conductrice, se terminant à une surface de ladite troisième couche semi-conductrice ;
une électrode de grille (8) constituée, par l'intermédiaire d'un film (7) d'isolation de grille, sur au moins une région de canal fournie par une surface de ladite troisième couche semi-conductrice dans une partie entre ladite deuxième couche semi-conductrice et ladite quatrième couche semi-conductrice ;
une électrode de source (11) en contact à la fois avec ladite troisième couche semi-conductrice et ladite quatrième couche semi-conductrice ;
une électrode de drain (12) destinée à délivrer un courant de drain à travers ladite première couche semi-conductrice ;
une surface de cellules, constituée par une pluralité desdites troisièmes couches semi-conductrices (3, 9) dans laquelle ladite électrode de grille (8), ladite électrode de source (11) et ladite électrode de drain (12) sont fournies respectivement en association à ladite pluralité desdites troisièmes couches semi-conductrices dans ladite surface de cellules ;
une surface d'anneau de garde (5) constituée entre ladite surface de cellules et une périphérie de ladite deuxième couche semi-conductrice afin de fournir une configuration en bande entourant ladite surface de cellules, comportant une partie incurvée ; et
une cinquième couche semi-conductrice (4) du deuxième type de conductivité, constituée entre ladite surface de cellules et ladite surface d'anneau de garde ;
***caractérisée en ce que :***
ladite électrode de source (11) comporte une pluralité de saillies (11b) reliées à ladite cinquième couche semi-conductrice (4) dans des premières régions de contact (23, 26) afin de fournir des dérivations au moyen desquelles, si une concentration de courant se produit dans ladite surface d'anneau de garde, on amène directement le courant concentré à ladite électrode de source dans ladite surface de cellules, et
qu'une liaison conductrice (15) est constituée sur ladite cinquième couche semi-conductrice (4) et est reliée à l'électrode de grille (8) dans au moins une deuxième région de contact (25, 27), dans laquelle
l'électrode de grille (8) est constituée entre les premières régions de contact (23, 26) de manière à ce que la pluralité de saillies (11b) et l'électrode de grille (8) soit alternativement disposées le long de la périphérie de la surface de cellules.

2. Transistor à effet de champ à grille isolée selon la revendication 1, dans lequel une desdites premières régions de contact (23, 26) est disposée sur une partie incurvée de ladite cinquième couche semi-conductrice (4).

3. Transistor à effet de champ à grille isolée selon les revendications 1 ou 2, dans lequel on fournit une pluralité de deuxièmes régions de contact (25, 27), qui sont disposées alternativement avec lesdites premières régions de contact (23, 26) le long de la périphérie de ladite surface de cellules.

4. Transistor à effet de champ à grille isolée selon la revendication 2, dans lequel, dans une partie de ladite surface de cellules adjacente à ladite partie incurvée de ladite cinquième couche semi-conductrice (4), ladite quatrième couche semi-conductrice (6) n'est pas disposée dans lesdites troisièmes couches semi-conductrices (3, 9).

5. Transistor à effet de champ à grille isolée selon la revendication 2, dans lequel, dans une partie de ladite surface de cellules adjacente à ladite partie incurvée de ladite cinquième couche semi-conductrice (4), on fournit une sixième couche semi-conductrice (24) du deuxième type de conductivité et on la relie à ladite électrode de source (11).

6. Transistor à effet de champ à grille isolée selon l'une quelconque des revendications 1 à 5, dans lequel ladite zone de cellules comprend des cellules en forme de bande ou de polygone.

7. Transistor à effet de champ à grille isolée selon l'une quelconque des revendications 1 à 6, dans lequel ladite partie incurvée dudit anneau de garde comprend soit une courbe régulière, soit plusieurs bords anguleux.
